# EUROPEAN PATENT APPLICATION

(11) **EP 1 916 069 A2**
(43) Date of publication of application: **30.04.2008**
(21) Application number: 07119386.6
(22) Date of filing: 26.10.2007
(51) Int. Cl.: B25F 5/00

(54) **Cordless power tool battery charging and analyzing system**

(30) Priority: 27.10.2006 US 854765 P
(71) Applicant: Ball, William M., Jr., Stockton NJ 08559 (US); Linehan, John J., Jamison NJ 18929 (US); Leight, Christopher P., Macungie PA 18062 (US)
(72) Inventor: Ball, William M., Jr., Stockton NJ 08559 (US); Linehan, John J., Jamison NJ 18929 (US); Leight, Christopher P., Macungie PA 18062 (US)
(74) Representative: Schwabe - Sandmair - Marx

(57) **Abstract**

A cordless power tool battery pack (10,10') including an onboard circuit (20) configured to electronically communicate with an associated battery charging system (50) and an associated battery analyzing system (100). The onboard circuit (20) communicates information relating to the battery pack (10,10') to a microprocessor (90) or the like within the battery charging system (50) and charging of the battery pack (10,10') is controlled based on such communication. The onboard circuit (20) also communicates information relating to the battery pack (10,10') to a microprocessor (90) or the like within the battery analyzing system (100) which can than be communicated to an interface unit (130) for display to a user.

## Description

### BACKGROUND OF THE INVENTION

The present Invention relates to cordless power tools, and more particularly, to batteries for cordless power tools and a charging system for charging such batteries and an analyzing system for analyzing such batteries.

Cordless power tools are well-known and provide several advantages over traditional corded power tools. One of the advantages provided by cordless power tools is the mobility and/or portability when using the tool. For example, the operator of the cordless power tool can quickly and efficiently work over a larger area without having to continually adjust the power cord. Similarly, cordless power tools can be used in areas where electrical power is not available. Because of these advantages, the popularity of cordless power tools has increased among both professional and novice power tool users.

It is desired to provide improved cordless power tool batteries, an improved charging system for such batteries and an improved analyzing system for such batteries.

### SUMMARY OF THE INVENTION

In one aspect, the invention may provide a cordless power tool battery including an onboard circuit configured to electronically communicate with an associated battery charging system. In one or more embodiments of the invention, the onboard circuit may contain identifying indicia relating to the battery chemistry, the battery voltage, the battery capacity and the like. In one or more embodiments of the invention, the onboard circuit may contain a charging protocol specific to the battery. In one or more embodiments of the invention, the onboard circuit may be configured to store data related to the battery, for example, a counter of the number of charges, a history of discharge and charge cycles, a history of battery renewing and the like. In one or more embodiments of the invention, the onboard circuit may be configured to communicate with the charging system even if the battery has no voltage.

In another aspect, the invention may provide a cordless power tool battery charging system. In one or more embodiments of the invention, the charging system may be configured to accept multiple input voltages. In one or more embodiments of the invention, the charging system may be configured to charge batteries having different battery chemistries. In one or more embodiments of the invention, the charging system may be configured to charge batteries having different voltages. In one or more embodiments of the invention, the charging system may be configured to charge batteries in accordance with a charging protocol stored in the battery. In one or more embodiments of the invention, the charging system may be configured to display the current charge level of a battery. In one or more embodiments of the invention, the charging system may be configured to compare a current capacity of a battery to an original capacity of a battery and, based thereon, recommend whether the battery should be renewed. In one or more embodiments of the invention, the charging system may be configured to renew a battery by deep discharging the battery and then recharging the battery.

In another aspect, the invention may provide a cordless power tool battery charging system configured to receive batteries having different housing configurations. In one or more embodiments of the invention, the charging system may include keyways configured to receive various battery key patterns. In one or more embodiments of the invention, the charging system may be configured such that the battery contacts and charging system contacts are disengaged prior to removal of the battery from the charging system. In one or more embodiments of the invention, the batteries may include an onboard circuit contact on a distal end surface thereof for contact with a corresponding contact in the charging system. In one or more embodiments of the invention, the charging system may include flexible battery contacts such that the battery contacts within the charging system housing. In one or more embodiments of the invention, the charging system may include a multifaceted heat sink extending therein. In one or more embodiments of the invention, the charging system may include a fan mounted on a heat sink and wherein the heat sink may further include through passages aligned with the fan.

In another aspect, the invention may provide a battery analyzing system. In one or more embodiments of the invention, the analyzing system may be configured to accept batteries having different input voltages. In one or more embodiments of the invention, the analyzing system may be configured to analyze batteries having different battery chemistries. In one or more embodiments of the invention, the analyzing system may be configured to analyze batteries having different voltages. In one or more embodiments of the invention, the analyzing system may be configured to display various aspects of the battery, for example, battery chemistry, the advertised pack voltage, date of birth, the unique battery pack id number, the number of charge cycles the battery pack has done, the current maximum capacity the battery pack can charge to, and the current charge level. In one or more embodiments of the invention, the analyzing system may be configured to compare a current capacity of a battery to an original capacity of a battery and, based thereon, recommend whether the battery should be renewed, or possibly replaced.

### BRIEF DESCRIPTION OF THE DRAWINGS

Fig. 1 is a perspective view of an exemplary Nickel Cadmium battery in accordance with a first embodiment of the present invention.
Fig. 2 is a perspective view of an exemplary Lithium Ion battery in accordance with an alternate embodiment of the present invention.
Fig. 3 is a top plan view of the battery of Fig. 2.
Fig. 4 is a perspective view of a charging system in accordance with the present invention.
Fig. 5 is a side elevation view of the charging system of Fig. 4.
Fig. 6 is a top plan view of the charging system of Fig. 4.
Fig. 7 is a top plan view similar to Fig. 6 illustrating the charging system of Fig. 4 with the housing top cover removed.
Fig. 8 is a elevational view along the line 8-8 of Fig. 7.
Fig. 9 is a top plan view of the charging system housing bottom cover.
Fig. 10 is an elevation view illustrating the placement of the charging system housing top cover relative to the housing bottom cover.
Fig. 11 is an exemplary circuit diagram of the battery of Fig. 1.
Fig. 12 is an exemplary circuit diagram of the battery of Fig. 2.
Fig. 13 is an exemplary circuit diagram of a buck circuit of the charging system of Fig. 4.
Fig. 14 is an exemplary circuit diagram of a microprocessor and LED circuit of the charging system of Fig. 4.
Fig. 15 is an exemplary circuit diagram of a flyback circuit of the charging system of Fig. 4.
Fig. 16 is a schematic drawing illustrating an exemplary analyzing system of the present invention.

### DETAILED DESCRIPTION OF THE INVENTION

Although the invention is illustrated and described herein with reference to specific embodiments, the invention is not intended to be limited to the details shown. Rather, various modifications may be made in the details within the scope and range of equivalents of the claims and without departing from the invention.

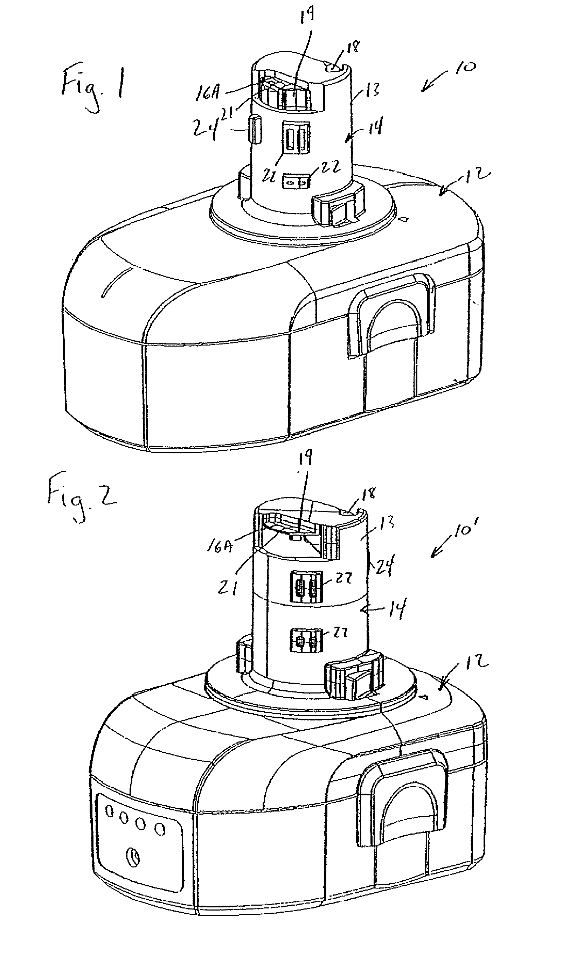

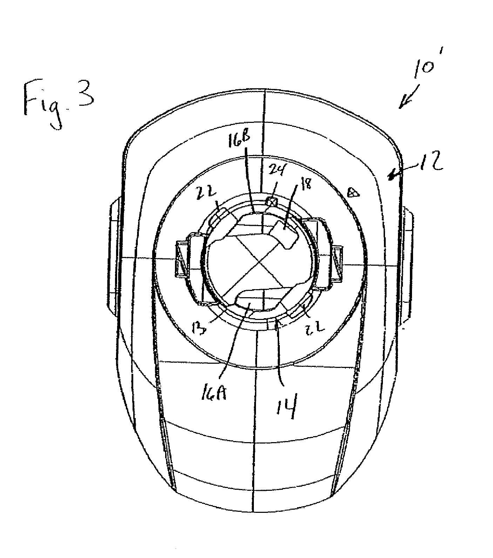

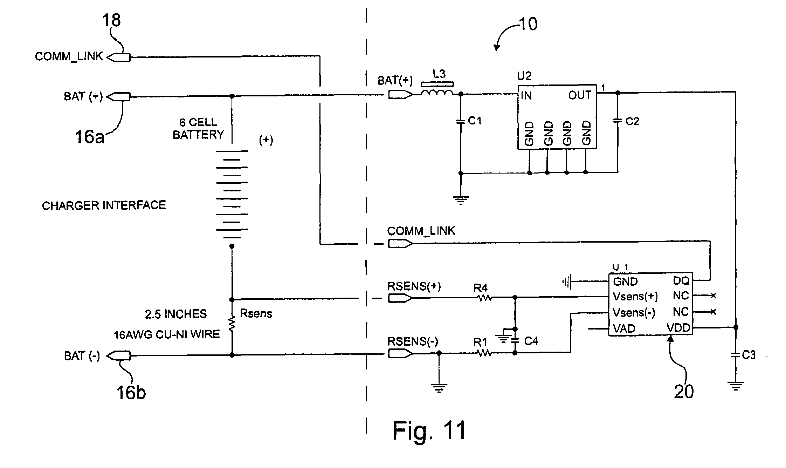

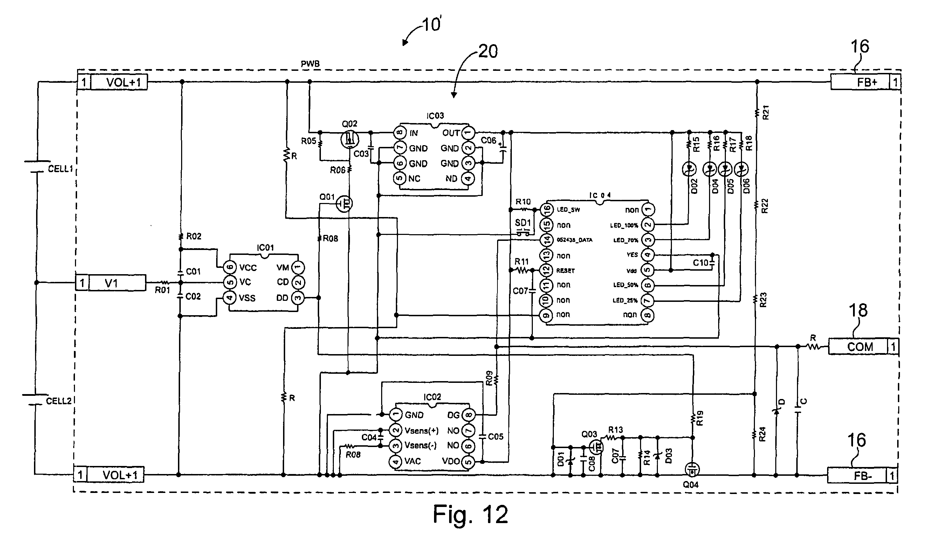

Referring to Figs. 1-3, two exemplary battery packs 10, 10' of the present invention are shown. The battery pack 10 illustrated in Fig. 1 is Nickel Cadmium batter cells while the battery pack 10' illustrated in Figs. 2 and 3 utilizes Lithium Ion batter cells. Exemplary circuit diagrams for both battery packs 10 and 10' are illustrated in Figs. 11 and 12, respectively.

Each battery pack 10, 10' includes a main housing 12 with a stem portion 14 extending therefrom. The main housing 12 and the stem portion 14 house the battery cells (not shown). The stem portion 14 preferably houses one or more of the battery cells. In each of the illustrated embodiments, the stem portion 14 has a cylindrical body 13 extending from the main housing 12 to an end cap 15. A pair of opposed openings 17 are provided in the body 13 adjacent to the end cap 15. The number and position of the openings 17 may be varied. The openings 17 are configured to expose the battery electrical contacts 16A and 16B which are electrically interconnected with the battery cells and the battery communication contact 18 which is electrically interconnected with the battery onboard circuit 20.

Referring to Figs. 1-3, each battery pack 10 and 10' includes various support keys 22 and alignment keys 24 extending radially outward from the stem portion body 13. The support keys 22 are configured to align with and rotatably engage support keyways in various portable tools. The support keys 22 and the alignment can be arranged in various configurations, including different widths, heights, positions, numbers and the like. In the preferred embodiment, the configuration of the support keys 22 and alignment key 24 are configured such that the battery pack 10, 10' is properly aligned with the power tool or charging system 50, as will be described hereinafter, such that the proper polarity of the contacts 16A and 16B is maintained.

In the preferred embodiment, each specific support key 22 and alignment key 24 configuration corresponds to a battery pack 10, 10' having a specific voltage such that the battery pack 10, 10' is useable only in power tools requiring such voltage and having corresponding keyways to receive the battery pack 10, 10'. Since the configuration of the keys 22 and the alignment keyway 24 are distinct for each voltage, the different voltage battery packs would not be capable of inadvertent use with the wrong tool.

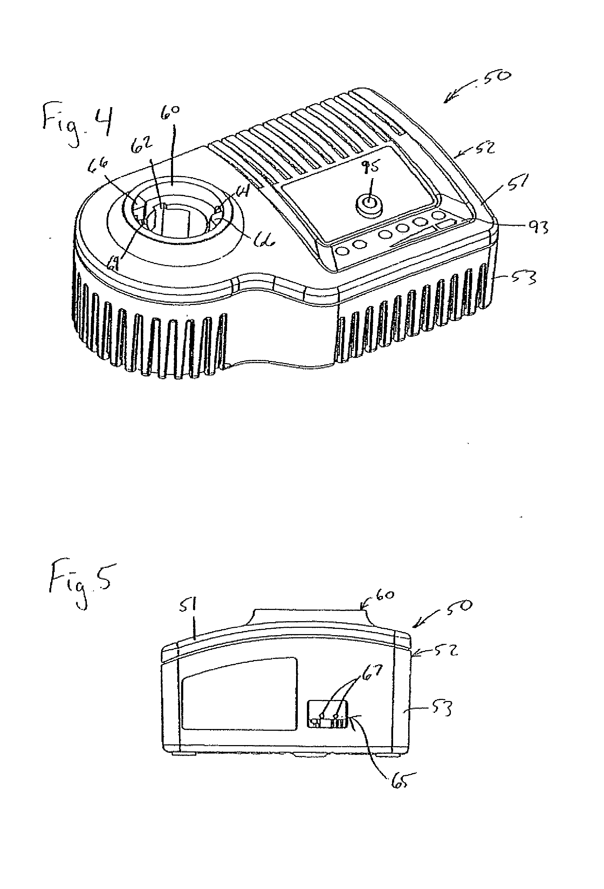

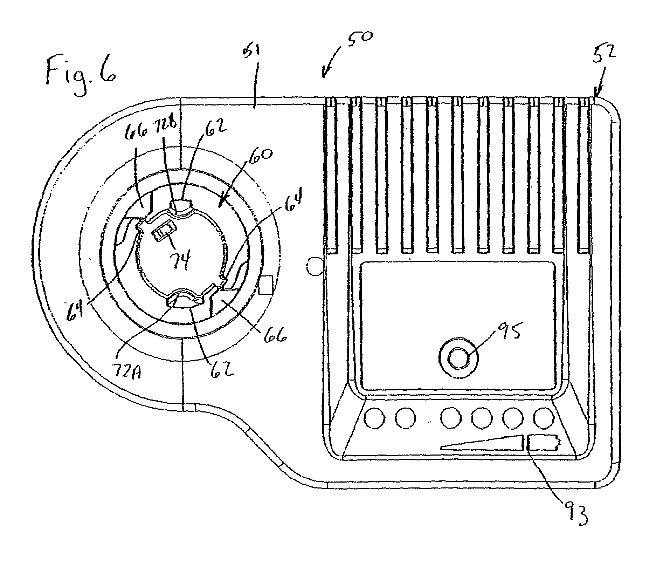

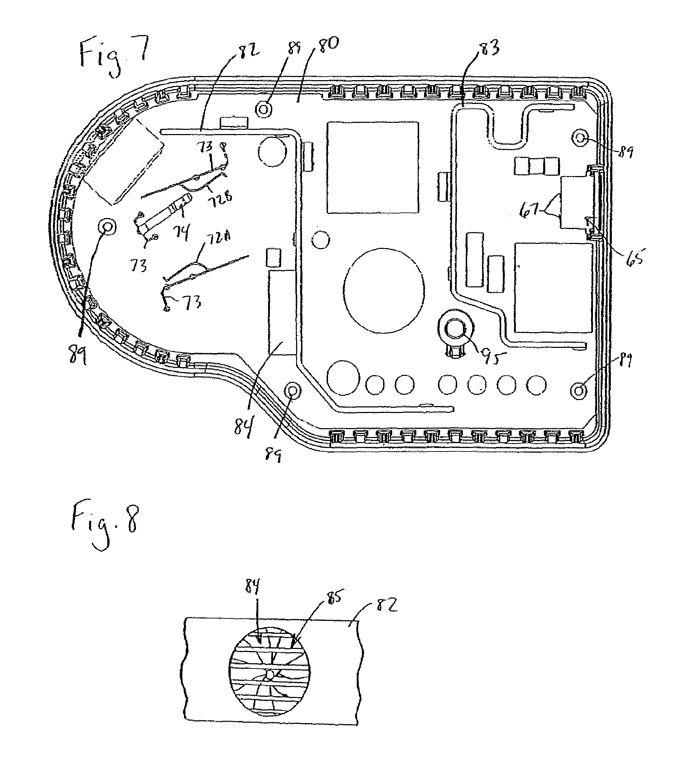

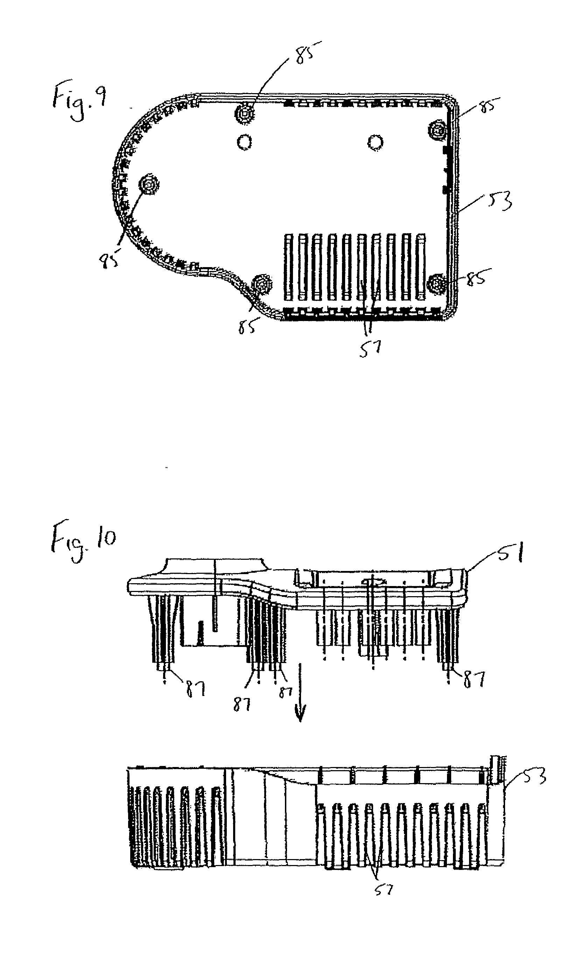

Referring to Figs. 4-10, a preferred embodiment of the charging system 50 will be described. The charging system 50 generally includes a housing 52 comprising an top cover 51 and a bottom cover 53. A battery stem receiving opening 60 is defined through the top cover 51. The opening 60 includes one or more support key keyways 62 and one or more alignment key keyways 64. The keyways 62 and 64 are configured to receive various configurations of battery pack support keys 22 and alignment keys 24, such that the charging system 50 provides a universal charger for various battery voltages. For example, the support key keyways 62 are typically wider than most, if not all of the support keys 22, such that, relative to other voltage key configurations, the keys 22 can be moved circumferentially and still align with the keyways 62. Stops 66 are preferably provided within the opening 60 such that the battery pack stem 14 can only be rotated a given amount within the opening 60.

To further facilitate universal usage of the charging system 50, the charging system 50 preferably includes a plug port 65 with male pins 67 configured to mate with the female plug of cords (not shown) useable with different input voltages. As illustrated in the circuit diagrams, the male pins 67 are associated with a voltage converter which allows the charging system to be utilized with different input voltages.

Referring to Figs. 6 and 7, the charging system 50 includes a pair of opposed electrical contacts 72A and 72B configured to electrically connect with the battery pack contacts 16A and 16B. Again, the configuration of the support keys 22 and alignment key 24 and the keyways 62 and 64 are configured such that the battery pack 10, 10' is properly aligned with the charging system 50 such that the proper polarity of the contacts 16A and 16B is maintained.

Each electrical contact 16A, 16B preferably includes a radially tapered portion 19 extending to an arcuate portion 21. The tapered portions 19 are configured to first contact the charger contacts 72A and 72B during rotation of the battery pack 10, 10' relative to the charging system 50 such that the charger contacts 72A, 72B ride along the tapered portions 19 and into final engagement with the arcuate portion 21. The tapered portion 19 may be made from conductive material, or alternatively, may be a non-conductive material. In the initially inserted position, prior to rotation into electrical contact, the battery pack contacts 16A and 16B are circumferentially offset from and thereby disengaged from the charger contacts 72A and 72B. As such, during axial movement of the battery pack stem 14 into the opening 60, the contacts 16A, 16B and 72A, 72B do not interfere with each other or apply any load upon each other.

A communication contact 74 extends from the circuit board 80 within the charging system 50 and is configured to engage the battery communication contact 18. Electrical connection between the battery communication contact 18 and the communication contact 74 provides a digital link between the onboard circuit 20 in the battery pack 10, 10' and a microprocessor 90 or the like in the charging system 50. An exemplary onboard circuit 20 is the DS2438 manufactured by Dallas Semiconductor, the specifications of which are incorporated herein by reference. The functions of the onboard circuit 20 and the microprocessor 90 will be described hereinafter.

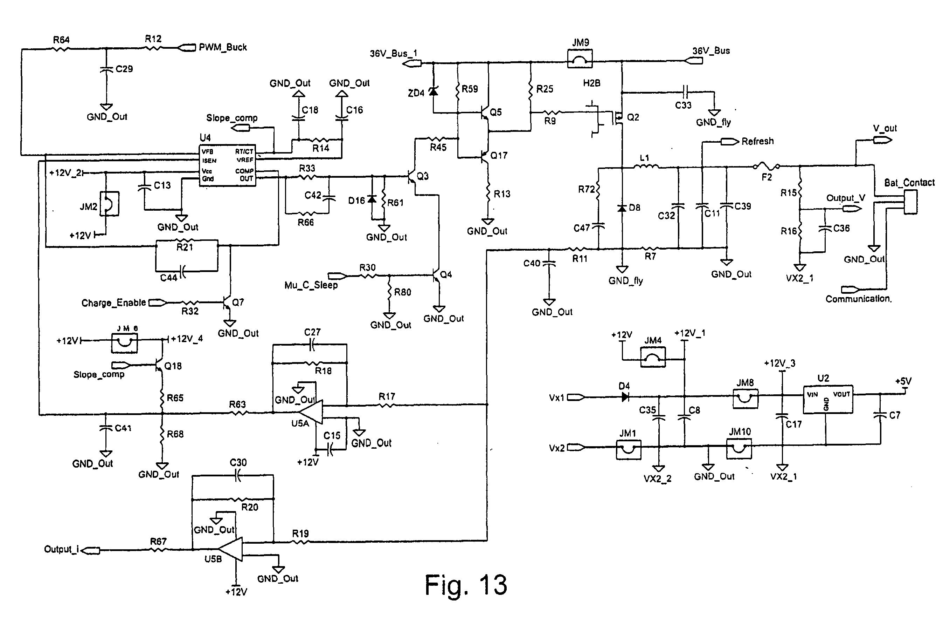

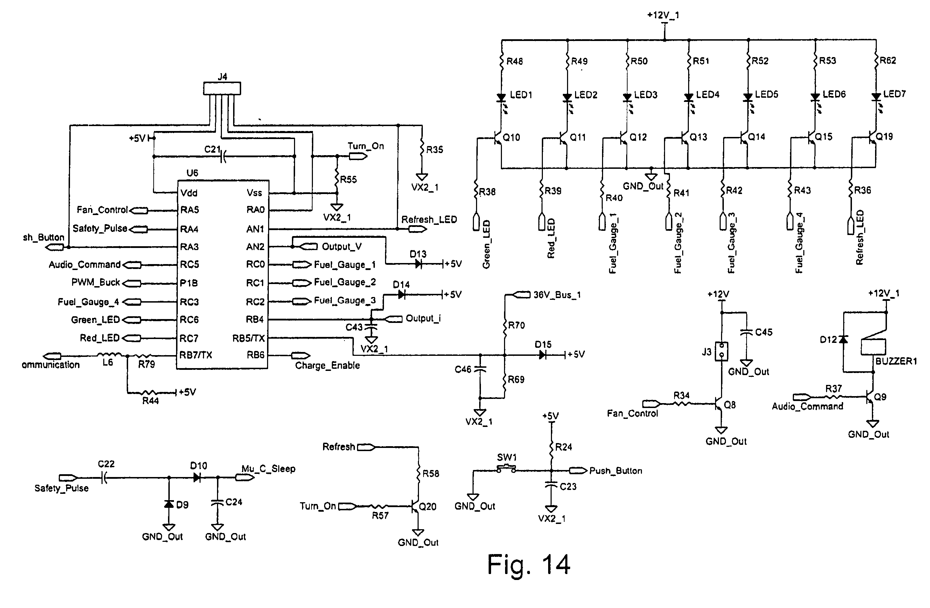

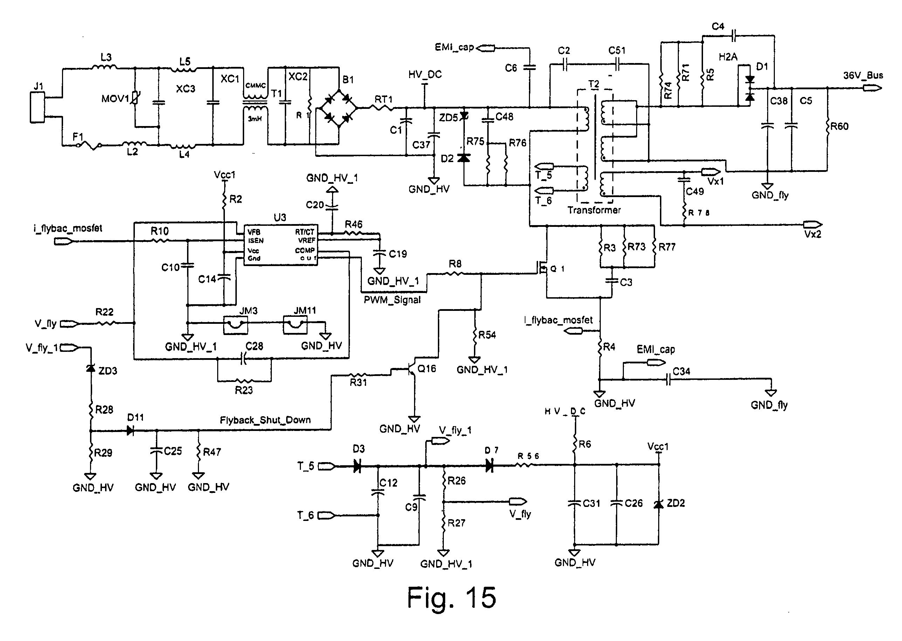

Referring to Fig. 7, the various components of the charging system 50 are mounted on a circuit board 80. Figs. 13-15 are exemplary circuit diagrams of various portions of the charging system 50 and illustrate various components used therein. Mechanical structures are also mounted on the circuit board 80. A pair of heat sinks 82 and 83 are mounted on the board 80 and are configured to remove heat from the electrical components. Each heat sink 82, 83 has a non-linear configuration to maximize the area of heat absorption surface. In the preferred embodiment, to further facilitate cooling, a fan 84 or the like is mounted onto heat sink 82. Referring to Fig. 8, a slotted vent structure 85 may be provided on the heat sink 82 in alignment with the fan 84 to draw or push air across the heat sink 82 to enhance cooling. The housing 52 also has various vent slots 57.

The charger contacts 72A and 72B and the communication contact 74 are each preferably mounted on the circuit board 80 via flexible mounts 73 such that when the top cover 51 is positioned relative to the bottom cover 53, the contacts 72A, 72B and 74 may flex and align with the appropriate areas within the opening 60. Referring to Figs. 7, 9 and 10, in the preferred embodiment, the circuit board 80 is supported on supports 85 within the bottom cover 53. The circuit board 80 preferably is not initially secured to the bottom cover 53 and is slightly adjustable relative thereto. The top cover 51 is placed onto the bottom cover 53, and feet 87 depending therefrom pass through holes 89 in the circuit board 80 such that the feet 87 engage the supports 85. Screws or the like are utilized to secure the feet 87 to the supports 85 and the circuit board 80 is maintained therebetween. The alignability of the circuit board 80 and the flexibility of the contacts 72A, 72B and 74 allows the charging system 50 to be easily assembled.

The battery onboard circuit 20 and the microprocessor 90 communicate with one another to facilitate various charging functions as herein described. The various components utilized in carrying out these functions are illustrated in the various circuit diagrams in Figs. 11-15. For example, the onboard circuit 20 preferably contains identifying indicia relating to the battery chemistry (i.e. NiCad vs. Lithium Ion), the battery voltage, the battery capacity and the like. This information is communicated to the microprocessor 90 to inform the charging system 50 the type of battery pack 10, 10' that has been placed in the charging system 50. The exchange of information occurs upon contact between the contacts 18 and 74. The onboard circuit 20 is independent of the stored charge within the battery pack 10, 10' and therefore the battery pack 10, 10' will be recognized by the charging system 50 even if the battery pack 10, 10' is completely drained. In the preferred embodiment, the onboard circuit 20 has stored in its memory a charging protocol specific to the battery pack 10, 10', In another aspect of the invention, the onboard circuit 20 may be configured to store data related to the battery pack 10, 10', for example, a counter of the number of charges, a history of discharge and charge cycles, the current maximum capacity to which the battery pack can charge, the current charge level, a history of battery renewing and the like.

Since the battery onboard circuit 20 provides the microprocessor 90 with specific information relating to the battery pack 10, 10', preferably including the charging protocol, the microprocessor 90 can regulate the voltage output and the like such that the charging system 50 can charge batteries 10, 10' having different battery chemistries or having different voltages. The microprocessor 90 is preferably configured to receive and display the current charge level of the battery pack 10, 10'. In this regard, the charging system 50 includes a charge level indicator 93 which may include a series of LEDs or the like. In the preferred embodiment, the microprocessor 90 is further configured to compare a current capacity of a battery pack 10, 10' to an original capacity of a battery pack 10, 10' (which is preferably stored in the memory of the onboard circuit 20) and, based thereon, recommend whether the battery pack 10, 10' should be renewed. To renew the battery pack 10,10', a user depresses the renew button 95 to start a renewing cycle. Upon depression of the renew button 95, the microprocessor 90 is configured to initiate a deep discharge of the battery pack 10, 10' and then recharge the battery pack 10, 10'. The discharge button 95 may be configured to light up upon detection of a condition in which a renew is recommend. Alternatively, the microprocessor may be configured to automatically renew the battery pack 10, 10' upon detection of such a condition.

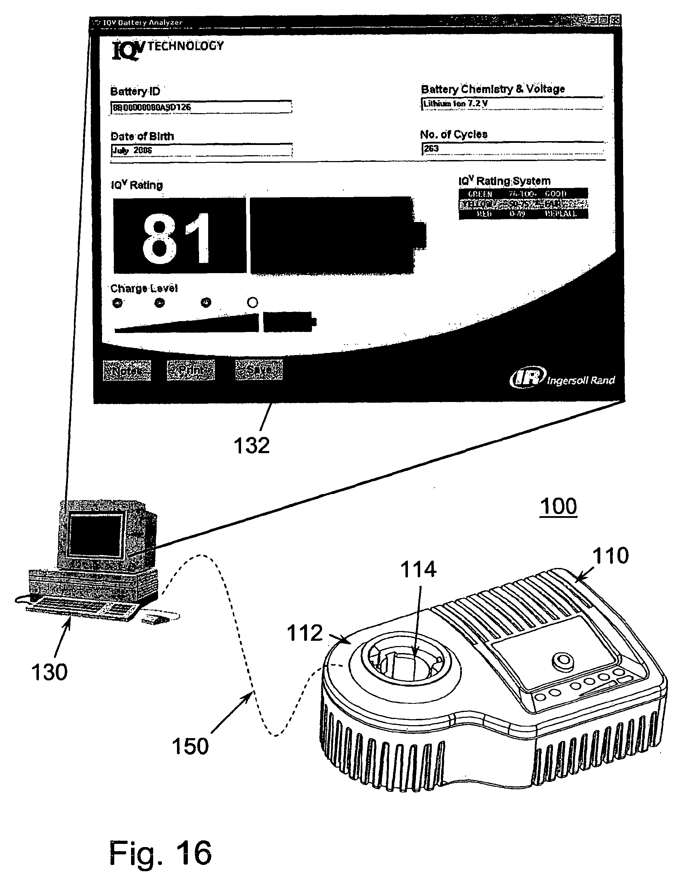

Referring to Fig. 16, a battery analyzing system 100 that is an embodiment of the present invention is shown. The battery analyzing system 100 generally includes a battery analyzer unit 11U configured to receive an intelligent battery 10 (not shown), an interface unit 130 configured to present the data stored on the battery 10, and a communication path 150 to facilitate communication between the battery analyzer 110 and the interface unit 1.30.

As explained above, the battery pack 10 contains circuitry that stores information describing the battery 10, for example, the amount of current that has flown into the battery pack and the amount of current that has flown out of the battery pack, the battery chemistry, the intended pack voltage, the manufacture date of the battery, the unique battery pack id number, the number of charge cycles the battery pack has done, the current maximum capacity to which the battery pack can charge, and the current charge level,

The battery analyzer unit 110 may have a configuration similar to the battery charging system 50 described above. The battery analyzer unit 110 generally includes a housing 112 with a battery stem receiving opening 114 extending into the housing 112. A communication contact (not shown) is provided within the stem receiving opening 114 and is configured to engage the battery communication contact 18. Electrical connection between the battery communication contact 18 and the analyzer communication contact provides a digital link between the onboard circuit 20 in the battery pack 10 and a microprocessor or the like in the analyzing unit 110. The microprocessor is configured to provide the battery information to the interface unit 130 via the communication path 150. While the battery analyzer unit 110 is shown as a separate unit from the battery charging system 50, the analyzing and charging functions may be incorporated into a single unit, with the single unit having the capability to both charge the battery 10 and transmit data to the interface unit 130.

The communication path 150 can have various configurations including wired or wireless communication methods. In one embodiment, the communication path 150 includes a set of contacts that connect to the battery pack's ground and communication terminals and circuitry that converts data from the intelligent battery 10 to the interface device 130. In the preferred embodiment, this converts from Dallas 1 wire standard to USB standard communications.

The interface unit 130 may be any computing device with a suitable display mechanism and communication means for receiving data over the communications path 150, For example, the interface unit 130 may be a computer processing unit or a handheld personal data assistant. The interface unit 130 includes software configured to receive the battery information from the battery analyzer unit 110 and to output useable information to an end user, In the preferred form, the interface unit 130 includes a screen to display desired battery information, but other output forms, for example, a printer, may also be utilized. An illustrative on screen display 132 is shown in Fig. 16. From the data presented on screen 132, the user can preferably quickly determine the status of the battery pack 10 and determine, for example, if the battery should be returned to the customer, or replaced under warranty or a new one sold.

The interface unit 130 may additionally or alternatively print a report about the battery pack 10 under test, and also save the test results to a file. In addition to the test results, the user has the ability to enter notes and comments about the battery pack 10. These notes may be included on the print out and attached to the saved file,

The battery analyzer system 100 allows a user to determine the status of a battery without applying some stress to the battery and inferring information from the response, as is typically done in prior art systems.

While preferred embodiments of the invention have been shown and described herein, it will be understood that such embodiments are provided by way of example only. Numerous variations, changes and substitutions will occur to those skilled in the art without departing from the spirit of the invention. Accordingly, it is intended that the appended claims cover all such variations as fall within the spirit and scope of the invention.

## Claims

1. A cordless power tool battery analyzing system comprising:
an analyzer unit configured to receive a battery, the analyzer unit including a microprocessor configured to receive battery information from a battery received by the analyzer unit; and
an interface unit configured to output battery information; and
a communication path over which battery information is transmitted from the analyzer unit to the interface unit.

2. The cordless power tool battery analyzing system according to claim 1 wherein the battery information includes an amount of current that has flown into the battery pack, an amount of current that has flown out of the battery pack, a battery chemistry, an intended pack voltage, a manufacture date of the battery, a battery pack id number, a number of charge cycles the battery pack has undergone, a current maximum capacity to which the battery pack can charge, a current charge level, or a combination thereof.

3. The cordless power tool battery analyzing system according to claim 1 wherein the battery analyzer includes an analyzer communication contact associated with the microprocessor and configured to engage a battery communication contact, and wherein battery information is received by the microprocessor upon engagement of the battery communication contact with the analyzer communication contact.

4. The cordless power tool battery analyzing system according to claim 1 wherein the communication path is a wired path between the analyzer and the interface unit, a wireless path between the analyzer and the interface unit, or a combination thereof.

5. The cordless power tool battery analyzing system according to claim 1 wherein the communication path includes a set of contacts that connect to a received battery, and circuitry that converts data from a received battery to the interface unit.

6. The cordless power tool battery analyzing system according to claim 5 wherein the circuitry converts from Dallas 1 wire standard to USB standard communications.

7. The cordless power tool battery analyzing system according to claim 1 wherein the interface unit is a computer processing unit or a handheld personal data assistant.

8. The cordless power tool battery analyzing system according to claim 1 wherein the interface unit is configured to receive the battery information from the battery analyzer unit and to output useable information to an end user.

9. The cordless power tool battery analyzing system according to claim 1 wherein the interface unit includes a screen to display battery information.

10. The cordless power tool battery analyzing system according to claim 1 wherein the interface unit includes a printer configured to output battery information.

11. The cordless power tool battery analyzing system according to claim 1 wherein the interface unit includes an input device configured for input of additional information.

12. The cordless power tool battery analyzing system according to claim 1 wherein the interface unit is configured to store battery information.

13. The cordless power tool battery analyzing system according to claim 1 wherein the microprocessor is configured to receive battery information from a battery received by the analyzer unit without applying a stress to the battery.

14. The cordless power tool battery analyzing system according to claim 1 further comprising a charging circuit configured to charge a battery received by the analyzer unit, the charging circuit configured to charge in accordance with various charging protocols in dependence on the battery received by the analyzer unit.

15. A cordless power tool battery analyzing system according to claim 14 wherein the charging protocol is based on the battery chemistry, the battery voltage, or a combination thereof.

16. A cordless power tool battery analyzing system according to claim 14 wherein the charging circuit is configured to charge the battery in accordance with a charging protocol stored in the battery.

17. A cordless power tool battery analyzing system according to claim 1 wherein the analyzer unit includes a battery receiving opening configured to receive batteries having different housing configurations.

18. A cordless power tool battery and analyzing system assembly comprising:
a cordless tool battery comprising:
at least one battery tell;
an onboard circuit configured to store battery information;
a battery communication contact; and
an analyzing system comprising:
an analyzer unit configured to receive the battery, the analyzer unit including a microprocessor configured to receive battery information from the battery;
an interface unit configured to output battery information; and
a communication path over which battery information is transmitted from the analyzer unit to the interface unit.

19. The cordless power tool battery and analyzing system assembly according to claim 18 wherein the battery information includes an amount of current that has flown into the battery pack, an amount of current that has flown out of the battery pack, a battery chemistry, an intended pack voltage, a manufacture date of the battery, a battery pack id number, a number of charge cycles the battery pack has undergone, a current maximum capacity to which the battery pack can charge, a current charge level, or a combination thereof.

20. The cordless power tool battery and analyzing system assembly according to claim 18 wherein the battery analyzer includes an analyzer communication contact associated with the microprocessor and configured to engage the battery communication contact, and wherein battery information is received by the microprocessor upon engagement of the battery communication contact with the analyzer communication contact without applying stress to the battery.

21. The cordless power tool battery and analyzing system assembly according to claim 18 further comprising a charging circuit configured to receive the battery information, the charging circuit configured to charge in accordance with various charging protocols in dependence on the received battery information.
